# EUROPEAN PATENT SPECIFICATION

(11) **EP 1 630 247 B1**
(45) Date of publication and mention of the grant of the patent: **22.04.2009**
(21) Application number: 05253090.4
(22) Date of filing: 19.05.2005
(51) Int. Cl.: C23C 14/08, C23C 14/00, G11B 5/39

(54) **Method for reactive sputter deposition of an ultra-thin metal oxide film**
Verfahren zum reaktiven Sputtern eines ultradünnen Metalloxid-Films
Méthode pour le dépôt d'une couche ultra-mince par pulvérisation cathodique réactive

(30) Priority: 26.08.2004 US 927888
(43) Date of publication of application: 01.03.2006
(73) Proprietor: Hitachi Global Storage Technologies Netherlands B.V., 1076 AZ Amsterdam (NL)
(72) Inventor: Mauri, Daniele, San Jose, CA95120 (US)
(74) Representative: Calderbank, Thomas Roger

(56) References cited:
- EP-A- 1 043 765
- WO-A-20/04015162
- DE-A1- 10 119 834
- DE-A1- 19 830 206
- US-A- 5 917 682
- US-A1- 2004 101 978
- US-B1- 6 313 463
- "START/STOP PROCESS FOR MAGNET RESISTIVE SENSOR DEPOSITION" IBM TECHNICAL DISCLOSURE BULLETIN, IBM CORP. NEW YORK, US, vol. 37, no. 8, 1 August 1994 (1994-08-01), page 387, XP000456461 ISSN: 0018-8689

## Description

This invention relates generally to a method for deposition of an ultra-thin metal oxide film onto a film of a metal different from the metal in the metal oxide film.

Ultra-thin metal oxide films have application in nanotechnology devices. The deposition of these films to ultra-thin thicknesses, e.g., less than approximately 100 Å, is especially difficult when the film onto which the metal oxide film is to be deposited is also a metal, but a metal different from the metal in the metal oxide. In addition there are applications where it is important to be able to deposit the metal oxide film while minimizing the oxidation of the underlying metal.

One application of such ultra-thin metal oxide films is as capping layers in giant magnetoresistive (GMR) sensors, which are widely used as magnetoresistive read heads in magnetic recording disk drives. Nonmagnetic metal oxides, e.g. TaOx or AlOx, have been proposed to cap the free ferromagnetic layer in GMR spin-valve read heads. The nonmagnetic metal oxide capping layers are sometimes called "specular reflection" layers because they act to confine electrons and thus increase the occurrence of spin-dependent scattering of electrons at the interface of the spacer layer and the free ferromagnetic layer. GMR read heads with nonmagnetic metal oxide capping layers are described in published patent application US 2002/0196589 A1 and U.S. Patent 6,709,767.

Another application for such ultra-thin metal oxide films is in magnetic tunnel junction (MTJ) devices. A MTJ is comprised of two ferromagnetic metal layers separated by an ultra-thin insulating metal oxide tunnel barrier. The various MTJ devices being developed include a nonvolatile magnetic random access memory (MRAM) with MTJ memory cells, as described in U.S. Patent 5,640,343; a magnetic tunnel transistor (MTT), as described by S. van Dijken, X. Jiang, and S. S. P. Parkin, "Room Temperature Operation of a High Output Magnetic Tunnel Transistor", Appl. Phys. Lett. 80, 3364 (2002); and a MTJ magnetic field sensor, such as a magnetoresistive read head for use in a magnetic recording disk drive as described in U.S. Patent 5,729,410.

An important property for a MTJ device is the signal-to-noise ratio (SNR). The magnitude of the signal is dependent upon the tunneling magnetoresistance (TMR), i.e., the change in resistance divided by the resistance (ΔR/R). However, the noise exhibited by the MTJ device is determined, in large part, by the resistance R of the device. Thus an MTJ device should have high TMR and low R**.** The resistance R of a MTJ is largely determined by the resistance of the insulating tunnel barrier for a device of given dimensions since the resistance of the electrical leads and the two ferromagnetic metal layers contribute little to the resistance.

The most common MTJ tunnel barrier is an amorphous aluminum oxide (Al₂O₃) film made by vacuum deposition of an aluminum layer followed by plasma or natural oxidation. For Al₂O₃ tunnel barriers it has been found that as the thickness is reduced to reduce the resistance R, the TMR is also typically reduced, most likely because of the formation of pin holes in the ultra-thin tunnel barriers.

More recently, MTJs with epitaxial tunnel barriers of magnesium oxide (MgO) have been investigated. See M. Bowen et al., "Large magnetoresistance in Fe/MgO/FeCo (001) epitaxial tunnel junctions", Appl. Phys. Lett. 79, 1655 (2001); and S. Mitani et al., "Fe/MgO/Fe(100) epitaxial magnetic tunnel junctions prepared by using in situ plasma oxidation", J. Appl. Phys. 90, 8041 (2003). These MgO tunnel barriers have been prepared by laser ablation, molecular beam epitaxy, and by the method used for amorphous Al₂O₃ tunnel barriers, i.e., conventional vacuum deposition followed by *in situ* plasma oxidation.

Metal oxide films formed from other than Al and Mg have also been proposed for MTJ tunnel barriers. These include oxides ofTi, Ta, Y, Ga and In, and oxides of these metals alloyed with Al and/or Mg, as described in U.S. Patents 6,359,289 and 6,756,128. The most widely described method for the deposition of these metal oxide films is also by conventional vacuum deposition followed by *in situ* plasma or natural oxidation.

The conventional method of forming the metal oxide tunnel barrier metal by vacuum deposition of the metal followed by oxidation is very delicate and must be re-optimized for every deposited metal thickness. This method can also be very slow due to the post-deposition oxidation step. Too little oxidation leaves behind under-oxidized metal, while too much oxidation attacks the underlying film. In both the under-oxidized and over-oxidized cases the MTJ performance can be severely degraded.

Thus, it is desirable to develop a process for forming an ultra-thin metal oxide film onto a film of a metal different from the metal in the metal oxide that does not suffer from the problems associated with the prior art processes, and that will enable the fabrication of MTJ devices with high TMR and low R.

EP 1043765 discloses a method of forming a thin film on the surface of a sample in which the thin film is deposited after the surface of a solid target material is cleaned by using a reactive gas changed into plasma by an ECR plasma method on the surface on the sample.

US6313463 discloses a method of making a detector material for a high performance microbolometer. Vanadium oxide is deposited by ion beam sputtering in three different steps.

DE 19830206 discloses a method in which a substrate is coated at least partially with crystalline aluminium oxide by hollow cathode gas flow sputtering. The sputtering is carried out in an atmosphere comprising argon containing 0.5-2% oxygen.

US2004/0101978 discloses a method of manufacturing a tunnelling magnetoresistance (TMR) sensor. A barrier layer is formed by depositing a metallic film in an argon gas in a DC magnetron sputtering module, depositing an oxygen-doped metallic film in mixed xenon and oxygen gases in an ion-beam sputtering module, and oxidizing these films in an oxygen gas in an oxygen treatment module.

"Start/stop process for magnetoresistive sensor deposition", IBM Technical Disclosure Bulletin, Vol. 37, No. 8, August 1994, discloses a process for sputtering three layers within one sputter cycle. The process comprises a presputter phase in which a shutter prevents sputtered material from being deposited on the substrate.

The present invention provides a method for forming a metal oxide film on an iron-containing metallic film in a sputter deposition chamber, comprising:
providing in the chamber a sputtering target of a first metal and a substrate on which the iron-containing metallic film is formed, the metal of the metallic film being different from the first metal;
activating the target to sputter deposit atoms of the first metal inside the chamber while protecting the metallic film from exposure to the sputtered atoms;
after activating the target, introducing oxygen into the chamber at a known flow rate;
after stabilizing the oxygen flow exposing the metallic film to reactively deposit an oxide of the first metal onto the metallic film; and
continuing the reactive deposition for a period of time and terminating activation of the target when the target voltage reaches a predetermined value, said time period and known flow rate selected to assure minimal oxidation of the target.

The method provides reactive sputter deposition of an ultra-thin film of an oxide of a first metal onto a film of a second metal in which oxidation of the second metal is minimized. The method can be part of the fabrication of a GMR sensor with a metal oxide capping layer to increase specular conductance, or part of the fabrication of a MTJ with the metal oxide film becoming the tunnel barrier of the MTJ. The metal oxide film is reactively sputter deposited in the presence of reactive oxygen (O₂) gas from a target consisting essentially of the first metal, with the sputtering occurring in the "high-voltage" state to assure that deposition occurs with the target in its metallic mode, i.e., no or minimal oxidation. When the metal oxide film is for a MTJ tunnel barrier, then the target is formed of a metal which may consist essentially of Al, Ti, Ta, Y, Ga or In; or an alloy of two or more of these metals; or an alloy of one or more of these metals with Mg; and the film of the second metal is an iron-containing film, typically a film of Fe or a CoFe alloy.

The walls of the sputter deposition chamber are first conditioned by applying power to activate the target for example in the presence of argon (Ar) inert sputtering gas, while the film of the second metal is protected for example by moveable shutter. This conditioning step coats the chamber walls with the first metal, and thus removes any "memory" of prior oxygen processes in the chamber, which is important for a repeatable reactive deposition process. With the shutter still protecting the film of the second metal, the reactive O₂ gas is introduced into the chamber at a predetermined flow rate. After the O₂ flow has stabilized, the shutter is opened and the target is activated for a specific time to achieve the desired tunnel barrier thickness. The specific time has been previously determined, from the known O₂ flow rate, to assure that the sputter deposition occurs while there is minimal oxidation of the target.

Because the metallic mode of the target has a finite lifetime, a set of O₂ flow rates and associated sputter deposition times may be established, with each flow rate at deposition time assuring that deposition occurs with the target in the metallic mode and resulting in a known tunnel barrier thickness. The commencement of target oxidation is typically associated with a decrease in target voltage, so the sputtering may also be terminated by monitoring the target voltage and terminating application of power to the target when the voltage reaches a predetermined value.

Since deposition should occur only while the target is in its metallic mode, it is desirable to complete the tunnel barrier while the target is still metallic. Thus if a thicker tunnel barrier is required it may be deposited in several layers, with the process described above repeated for each layer. Also, if a multilayer tunnel barrier with different metal oxide or metal-alloy oxide layer is desired, the process described above may be repeated for each layer, but with a different target made of the desired metal or metal alloy.

As an optional final step, after the sputtering has terminated, the deposited metal oxide tunnel barrier may be exposed to O₂ in the chamber as a "natural oxidation" to encourage the metal oxide tunnel barrier to achieve its natural stoichiometry.

For a fuller understanding of the nature and advantages of the present invention, reference should be made to the following detailed description taken together with the accompanying figures.

### In the drawings:

Fig. 1 is a schematic top view of a conventional magnetic recording hard disk drive with the cover removed.

Fig. 2 is an enlarged end view of the slider and a section of the disk taken in the direction 2-2 in Fig. 1.

Fig. 3 is a view in the direction 3-3 of Fig. 2 and shows the ends of the read/write head as viewed from the disk.

Fig. 4 is a cross-sectional view of a MTJ read head showing the stack of layers, including the tunnel barrier, located between the magnetic shield layers.

Fig. 5 is a schematic of the sputter deposition equipment used in the process of this invention.

Fig. 6 is a hysteresis curve for the reactive sputter deposition of MgO from a Mg target with O₂ as the reactive gas and Ar as the inert sputtering gas.

Fig. 7 is a family of curves of Mg target voltages as a function of time for a set of different O₂ flow rates.

The method of this invention has application to the formation of the tunnel barrier required for a MTJ read head. However, the method is fully applicable to forming tunnel barriers for other MTJ devices, as well as for the more general application of forming an ultra-thin (less than approximately 100 Å or 10 nm) metal oxide film on a film of a different metal.

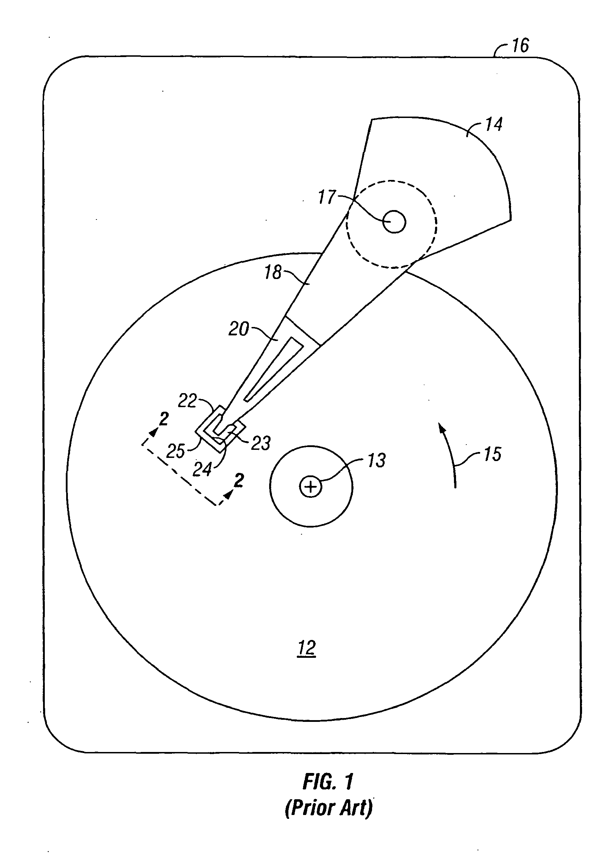

Because the MTJ read head has application for use in a magnetic recording disk drive, the operation of a conventional hard disk drive (HDD) will be briefly described with reference to Figs. 1-3. Fig. 1 is a block diagram of a conventional magnetic recording hard disk drive 10. The disk drive 10 includes a magnetic recording disk 12 and a rotary voice coil motor (VCM) actuator 14 supported on a disk drive housing or base 16. The disk 12 has a center of rotation 13 and is rotated in direction 15 by a spindle motor (not shown) mounted to base 16. The actuator 14 pivots about axis 17 and includes a rigid actuator arm 18. A generally flexible suspension 20 includes a flexure element. 23 and is attached to the end of arm 18. A head carrier or air-bearing slider 22 is attached to the flexure 23. A magnetic recording read/write head 24 is formed on the trailing surface 25 of slider 22. The flexure 23 and suspension 20 enable the slider to "pitch" and "roll" on an air-bearing generated by the rotating disk 12. Typically, there are multiple disks stacked on a hub that is rotated by the spindle motor, with a separate slider and read/write head associated with each disk surface.

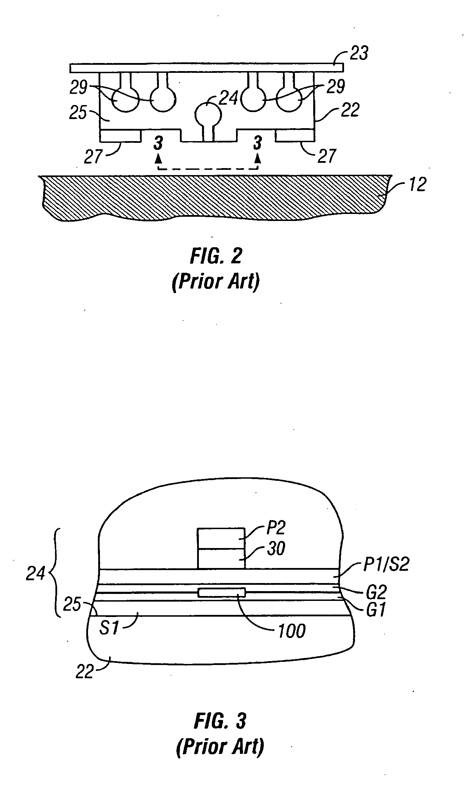

Fig. 2 is an enlarged end view of the slider 22 and a section of the disk 12 taken in the direction 2-2 in Fig. 1. The slider 22 is attached to flexure 23 and has an air-bearing surface (ABS) 27 facing the disk 12 and a trailing surface 25 generally perpendicular to the ABS. The ABS 27 causes the airflow from the rotating disk 12 to generate a bearing of air that supports the slider 20 in very close proximity to or near contact with the surface of disk 12. The read/write head 24 is formed on the trailing surface 25 and is connected to the disk drive read/write electronics by electrical connection to terminal pads 29 on the trailing surface 25.

Fig. 3 is a view in the direction 3-3 of Fig. 2 and shows the ends of read/write head 24 as viewed from the disk 12. The read/write head 24 is a series of thin films deposited and lithographically patterned on the trailing surface 25 of slider 22. The write head includes magnetic write poles P1/S2 and P1 separated by a write gap 30. The magnetoresistive sensor or read head 100 is located between two insulating gap layers G1, G2 that are typically formed of alumina. Gap layers G1, G2 are located between magnetic shields S1 and P1/S2, with P1/S2 also serving as the first write pole for the write head. If the magnetoresistive read head is the type where the sense current is perpendicular to the planes of the layers, sometimes referred to as a CPP sensor, then the read head is formed in contact with the shields S1, S2, or in contact with electrically conducting leads formed on the shields. A MTJ read head is a CPP sensor.

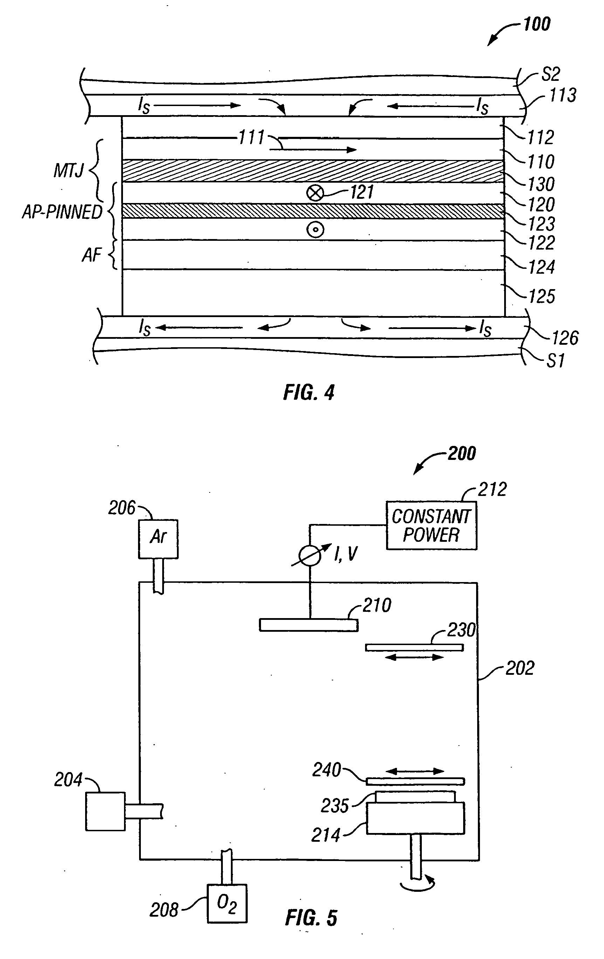

Fig. 4 is an enlarged sectional view showing the layers making up sensor 100. Sensor 100 is a MTJ read head comprising a stack of layers formed between the two magnetic shield layers S1, S2 that are typically electroplated NiFe alloy films. The lower shield S1 is typically polished by chemical-mechanical polishing (CMP) to provide a smooth substrate for the growth of the sensor stack. The sensor layers include a reference ferromagnetic layer 120 having a fixed or pinned magnetic moment or magnetization direction 121 oriented transversely (into the page), a free ferromagnetic layer 110 having a magnetic moment or magnetization direction 11 that can rotate in the plane of layer 110 in response to transverse external magnetic fields, and a nonmagnetic tunnel barrier 130 between the reference layer 120 and free layer 110. The two ferromagnetic layers 120, 110 and the tunnel barrier 130 together comprise the MTJ. The reference layer 120 is shown in Fig. 4 as part of the well-known antiparallel-pinned (AP-pinned) structure; also called a "laminated" pinned layer, as described in U.S. Patent 5,465,185. The AP-pinned structure minimizes magnetostatic coupling of the reference layer 120 with the free layer 110, and comprises the ferromagnetic reference layer 120 and a ferromagnetic pinned layer 122 separated by a nonmagnetic antiferromagnetically-coupling spacer layer 123, such as Ru. The ferromagnetic pinned layer 122 is exchange-coupled to an antiferromagnetic (AF) layer 124. The reference layer 120 can also be a single layer exchange-coupled with antiferromagnetic layer 124.

Located between the lower shield layer S 1 and the MTJ are the bottom electrode or electrical lead 126 and a seed layer 125. The seed layer 125 facilitates the deposition of the antiferromagnetic layer 124. Located between the MTJ and the upper shield layer S2 are a capping layer 112 and the top electrode or electrical lead 113.

In the presence of an external magnetic field in the range of interest, i.e., magnetic fields from recorded data on the disk 12, the magnetization direction 111 of free layer 110 will rotate while the magnetization direction 121 of reference layer 120 will remain fixed and not rotate. Thus when a sense current Is is applied from top lead 113 perpendicularly through the stack to bottom lead 126, the magnetic fields from the recorded data on the disk will cause rotation of the free-layer magnetization 111 relative to the pinned-layer magnetization 121, which is detectable as a change in electrical resistance.

The leads 126, 113 are typically Ta. They are optional and used to adjust the shield-to-shield spacing. The seed layer 125 is typically one or more layers of NiFeCr, NiFe, Ta or Ru. The antiferromagnetic layer 124 is typically a Mn alloy, e.g., PtMn, NiMn, FeMn, IrMn, PdMn, PtPdMn or RhMn. The capping layer 112 provides corrosion protection and is typically formed of Ru or Ta. A hard magnetic layer (not shown) may also be included in the stack for magnetic stabilization of the free ferromagnetic layer 110.

The ferromagnetic layers 123, 120, 110 are typically formed of an alloy of one or more of Co, Fe and Ni, or a bilayer of two alloys, such as a CoFe-NiFe bilayer. For example, reference ferromagnetic layer 120 may be a CoFe alloy, typically 10 to 30 Å or 1.0 to 3.0 mn thick, and the free ferromagnetic layer 110 may be a bilayer of a GoFe allow, typically 10-15 Å thick or 1.0-1.5 nm thick, and formed on the tunnel barrier 130, with the NiFe alloy, typically 10-30 Å or 1.0-3.0 mn thick, formed on the CoFe layer of the bilayer.

The invention will be explained with respect to forming a magnesium oxide (MgO) tunnel barrier on an iron-containing film, more particularly a CoFe alloy ferromagnetic film. Thus in this example the first metal is Mg and the second metal is Fe or an Fe alloy. It is understand, however, that the method is applicable for forming any ultra-thin metal oxide film on a film of a different metal.

Fig. 5 is a schematic of the sputter deposition equipment 200, which may be an Anelva® Model C7100 or similar sputtering equipment. The equipment 200 comprises a vacuum chamber 202, a cryogenic pump 204, an inert gas supply 206, a reactive gas supply 208, a sputtering target 210, a power supply 212 connected to the target 210, and a rotatable platform 214 for the substrate. Also included are a shutter 230 to cover the target and a shutter 240 to cover the substrate 235.

The process will be described for depositing an ultra-thin(approximately 5-20 Å or 0.5-2.0 nm) MgO tunnel barrier on an iron-containing metallic film, e.g., a Co₉₀Fe₁₀ ferromagnetic film. The MgO tunnel barrier is tunnel barrier 130, the Co₉₀Fe₁₀ film is reference ferromagnetic layer 120, and the substrate is the polished shield layer S 1, as described above with reference to Fig. 4. The target 210 is substantially pure Mg metal, the preferred inert gas is argon (Ar) and the preferred reactive gas is oxygen gas (O₂). Prior to the process for forming the MgO tunnel barrier the other layers in the sensor 100 can be deposited in the same vacuum deposition system, using sputtering targets of the appropriate material. Thus the last step prior to the first step in the MgO tunnel barrier deposition process is the sputter deposition of the Co₉₀Fe₁₀ film 120.

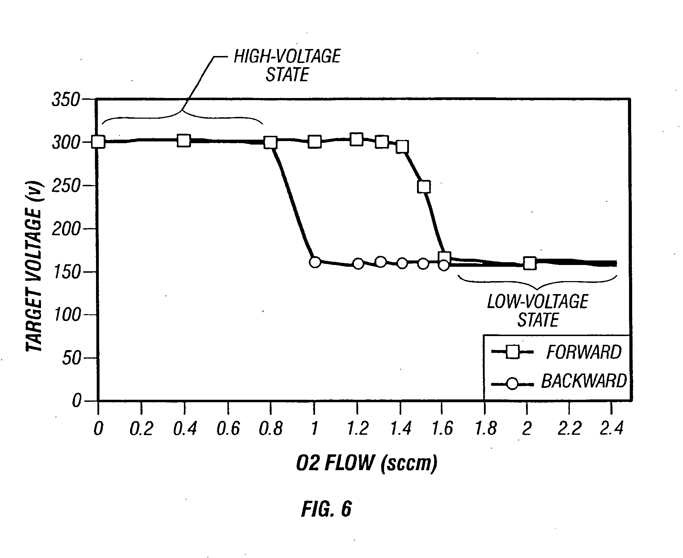

The method of this invention can be understood with reference to Fig. 6, which is a hysteresis curve for the reactive sputter deposition of MgO from a Mg target with O₂ as the reactive gas and Ar as the inert sputtering gas. In the case described with reference to Fig. 6, MgO is deposited from a metallic Mg target using pulsed DC sputtering. In the hysteresis curve the target voltage is plotted vs. the O₂ gas flow rate, while the Ar gas is kept at a fixed flow rate. The curve is hysteretic, i.e., the target voltage curve is different for increasing and decreasing O₂ flow rates.

Fig. 6 shows that the target has two stable states: a high-voltage state (approximately 300V) and a low-voltage state (approximately 150V). In the high-voltage state the target surface is metallic. This state is stable at very low O₂ flow rates. In the low-voltage state the target surface is oxidized. This state is stable at high O₂ flows, and is often referred to as the "poisoned" state because the target has become oxidized.

The poisoned state would appear to be the preferred state to perform the reactive deposition of the MgO film because it is easier to control, it deposits the MgO at a much lower rate than the high-voltage state, and the deposited MgO film is reliably well oxidized. However, as part of the development of the process of this invention it has been discovered that reactive deposition of MgO in the low-voltage or poisoned state is very aggressive to the underlying iron-containing metallic film on which the MgO is deposited. This results in a loss of magnetic moment at the interface of the CoFe ferromagnetic film and the MgO tunnel barrier. The MTJs fabricated in this state thus have undesirable high resistance (R) and low tunneling magnetoresistance (TMR).

The method of this invention reactively sputter deposits the MgO tunnel barrier in the high-voltage state. The reactive gas flow rate and sputter time are controlled to assure there is no substantial oxidation of the Mg target.

As an initial optional step in the inventive process, the target shutter 230 and substrate shutter 240 are both closed and pure Ar is introduced to the vacuum chamber 202. The target 210 is then activated and sputtered in the presence of pure Ar to eliminate any oxidized material from the target.

Next, with the target shutter 230 open and the substrate shutter 240 closed, the target 210 is again sputtered in pure Ar at sufficiently high power, e.g., 3W/sqcm. This step conditions the chamber 202 by coating the chamber walls with the Mg metal. Because the chamber walls are metallic and an active oxygen-gettering surface, they provide additional O₂ pumping, thus delaying the onset of target oxidation. The coating of the walls with Mg removes any "memory" of prior oxygen processes in the chamber, which is important for a repeatable reactive deposition process. The substrate shutter 240 protects the CoFe metallic film on the substrate from exposure to the sputtered Mg atoms during this chamber conditioning step.

Next, with the target shutter 230 still open and the substrate shutter 240 still closed, the oxygen gas is introduced into the chamber at the desired flow rate. After the O₂ flow has stabilized, the substrate shutter 240 is opened while the desired power is applied to the Mg target 210 to begin the reactive deposition of the tunnel barrier. The power is applied for a time required to achieve the desired deposited thickness. It has been previously determined that sputter deposition occurs while there is minimal oxidation of the Mg target, at the desired O₂ flow rate.

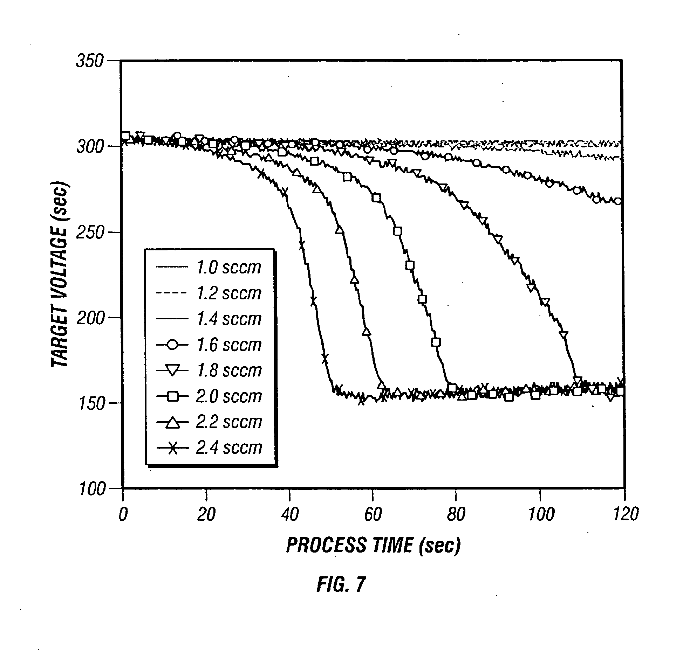

An important aspect of the process is that for each O₂ flow rate, the metallic mode of the Mg target has a finite lifetime. This is illustrated in Fig. 7, which shows a family of curves of target voltages with time. The objective is to sputter deposit at close to the initial target voltage, and terminate sputtering when the target voltage begins to decrease. A decrease in the target voltage indicates the beginning of oxidation of the target, which is undesirable. For example, for an O₂ flow rate of 1.8 sccm the Mg target stays substantially metallic for approximately 50 sec, after which significant oxidation occurs. During this 50 second time period, the target voltage has decreased to approximately 95% of its initial value. Thus the sputtering can also be terminated by monitoring the target voltage and terminating application of power to the target when the voltage reaches a predetermined value, e.g., 95% of its initial value. The total MgO thickness deposited in the initial high voltage period can, if sufficiently large, protect the CoFe electrode from the subsequent exposure to MgO deposition at falling target voltages, i.e., during target poisoning. However, it is best to avoid deposition as the target begins to be "poisoned" because the deposition rate is changing rapidly in the poisoning phase, making MgO thickness control difficult.

Thus the data of Fig. 7 allows a set of O₂ flow rates and associated time periods to be accumulated. Each member of the set will result in the deposition of a MgO tunnel barrier of a particular thickness. As a result, the desired O₂ flow rate and associated time period can be selected to deposit a MgO tunnel barrier of the desired thickness. Since it is desired to deposit while the Mg target is in metallic mode, i.e., no significant oxidation, the tunnel barrier must be completed while the target is still metallic. If a thicker tunnel barrier is required it can be deposited in several layers, with the process described above repeated for each layer.

Instead of reactively sputter depositing a MgO tunnel barrier, other metal oxide tunnel barriers may be formed from other targets with the method of this invention. Thus oxides of Al, Ti, Ta, Y, Ga or In may be formed as tunnel barriers by use of a target made of the desired metal. Also, the tunnel barrier may be made of an oxide of a metal alloy of two or more of these metals, or an oxide of one or more of these metals alloyed with Mg, by use of the desired metal alloy as the target.

The method of this invention also enables the fabrication of multilayer tunnel barriers, such as proposed in U.S. Patent 6,347,049. These tunnel barriers have at least two of the tunnel barrier layers in the multilayer formed from different metal oxides or metal-alloy oxides. Examples include Al₂O₃/MgO or MgO/Al₂O₃ bilayers and MgO/Al₂O₃/MgO or Al₂O₃/MgO/Al₂O₃ trilayers. Thus to form a multilayer metal oxide or metal-alloy oxide tunnel barrier layer according to this invention, the process described above is repeated for each layer, but with a different target made of the desired metal or metal alloy.

While depositing in the metallic mode is very beneficial, the resulting MgO film must be well-oxidized. This requirement leads toward higher oxygen flow rates and thus toward a shorter metallic mode lifetime. This situation can be mitigated by the use of an optional final step of exposing the deposited MgO tunnel barrier to O₂ in the chamber. For example, an O₂ exposure of 100 mTorr (or 13.3 GPa) for approximately 60 seconds is a "natural oxidation" step that encourages the tunnel barrier to achieve its natural MgO stoichiometry, and allows the use of lower O₂ flows during the reactive sputtering.

A second iron-containing film can then be sputter deposited directly on the tunnel barrier to form the top ferromagnetic layer of the MTJ. If the MTJ is to be used in the MTJ read head described above the second iron-containing film can be a CoFe free ferromagnetic layer 110 (Fig. 4).

The MTJs made with the method of this invention have TMR and resistance-area product (RA) values significantly improved over previously reported MTJs with MgO tunnel barriers. Two typical MTJs made according to the method of this invention have a TMR of approximately 35% with a RA of approximately 3.5 Ω-(µm)² and a TMR of approximately 40% with a RA of approximately 5 Ω-(µm)². In addition, the method of this invention minimizes oxidation of the underlying second metal. In the case of an MTJ a "clean" interface of CoFe/MgO, i.e., substantially no oxides of Co or Fe at the interface, is believed to lead to improved magnetoresistance.

While the method of this invention has been described for fabricating a MTJ read head, the method is fully applicable to fabricate other MTJ devices, including MTJ memory cells and MTTs. In addition the method has application to the fabrication of other nanotechnology devices, such as giant magnetoresistive (GMR) sensors where the metal oxide layer is used to increase specular conductance.

While the present invention has been particularly shown and described with reference to the preferred embodiments, it will be understood by those skilled in the art that various changes in form and detail may be made without departing from the invention. Accordingly, the disclosed invention is to be considered merely as illustrative and limited in scope only as specified in the appended claims, as interpreted by the description and drawings.

## Claims

1. A method for forming a metal oxide film on an iron-containing metallic film in a sputter deposition chamber comprising:
providing in the chamber a sputtering target of a first metal and a substrate on which the iron-containing metallic film is formed, the metal of the metallic film being different from the first metal,
activating the target to sputter deposit atoms of the first metal inside the chamber while protecting the metallic film from exposure to the sputtered atoms;
after activating the target, introducing oxygen into the chamber at a known flow rate;
after stabilizing the oxygen flow exposing the metallic film to reactively deposit an oxide of the first metal onto the metallic film; and
continuing the reactive deposition for a period of time and terminating activation of the target when the target voltage reaches a predetermined value, said time period and known flow rate selected to assure minimal oxidation of the target.

2. The method of claim 1 further comprising, prior to activating the target to sputter deposit atoms of the first metal inside the chamber while protecting the metallic film from exposure to the sputtered atoms, activating the target in the presence of an inert gas while covering the target to thereby substantially remove oxygen from the surface of the target.

3. The method of claim 1 further comprising, prior to activating the target to sputter deposit atoms of the first metal inside the chamber while protecting the metallic film from exposure to the sputtered atoms, etching the surface of the metallic film.

4. The method of claim 1 further comprising, after reactive deposition for said time period, exposing the deposited oxide of the first metal to oxygen in the chamber.

5. The method of claim 1 further comprising, prior to activating the target to sputter deposit atoms of the first metal inside the chamber while protecting the metallic film from exposure to the sputtered atoms, determining a set of known oxygen flow rates and associated time periods.

6. The method of claim 5 wherein determining said set comprises activating the target and, for each known flow rate in the set, measuring the decrease in the target voltage with time.

7. The method of claim 1 wherein, as a result of the reactive deposition a film of an oxide of the first metal has been deposited to a first thickness on the metallic film, and further comprising repeating the method of claim 1 to thereby increase said thickness.

8. The method of claim 2 wherein the inert gas is argon.

9. The method of claim 1 wherein the introduced oxygen is introduced as O₂ gas.

10. The method of claim 1 further comprising providing a shutter for the substrate, wherein protecting the metallic film comprises locating the shutter over the substrate, and wherein exposing the metallic film comprises removing the shutter from over the substrate.

11. The method of claim 1, wherein the metal of the metallic film is Fe or a Fe alloy.

12. The method of claim 1 wherein the first metal is selected from the group consisting of Al, Ti, Ta, Y, Ga and In.

13. the method of claim 1 wherein the first metal is an alloy of two or more metals selected from the group consisting of Al, Ti, Ta, Y, Ga, In and Mg.

14. The method of claim 1 further comprising, after the reactive deposition of a film of an oxide of the first metal, repeating the method of claim 1 to reactively sputter deposit a film of an oxide of a metal different from the first metal and the metal of the metallic film to thereby form a multilayer metal oxide film.

## Patentansprüche

1. Verfahren zur Ausbildung eines Metalloxidfilms auf einem eisenhältigen Metallfilm in einer Sputterabscheidungskammer, umfassend:
die Bereitstellung eines Sputtertargets eines ersten Metalls und eines Substrats, auf dem der eisenhältige Metallfilm ausgebildet ist, in der Kammer, wobei sich das Metall des Metallfilms von dem ersten Metall unterscheidet;
die Aktivierung des Targets, um Deposit-Atome des ersten Metalls innerhalb der Kammer zu sputtern, während der Metallfilm davor geschützt wird, der Einwirkung der gesputterten Atomen ausgesetzt zu sein;
nach der Aktivierung des Targets das Einbringen von Sauerstoff in die Kammer mit einer bekannten Strömungsgeschwindigkeit;
nach dem Stabilisieren des Sauerstoffstroms das Aussetzen des Metallfilms einer Einwirkung um ein Oxid des ersten Metalls auf dem Metallfilm reaktiv abzuscheiden; und
die Fortführung der reaktiven Abscheidung über eine bestimmte Zeitdauer und Beenden der Aktivierung des Targets, wenn die Targetspannung einen vorbestimmten Wert erreicht, wobei die Zeitdauer und die bekannte Strömungsgeschwindigkeit so gewählt werden, dass sie eine minimale Oxidation des Targets sicherstellen.

2. Verfahren nach Anspruch 1, weiters umfassend - vor der Aktivierung des Tagets, um Deposit-Atome des ersten Metalls innerhalb der Kammer zu sputtern, während der Metallfilm davor geschützt wird, den Sputteratomen ausgesetzt zu sein - die Aktivierung des Targets in Gegenwart eines Inertgases, während das Target abgedeckt wird, um dadurch Sauerstoff im Wesentlichen aus der Targetoberfläche zu entfernen.

3. Verfahren nach Anspruch 1, weiters umfassend - bevor das Target aktiviert wird, um Deposit-Atome des ersten Metalls innerhalb der Kammer zu sputtern, während der Metallfilm davor geschützt wird, den Sputteratomen ausgesetzt zu sein - das Ätzen der Oberfläche des Metallfilms.

4. Verfahren nach Anspruch 1, weiters umfassend - nach der reaktiven Abscheidung über eine bestimmte Zeitdauer - das Aussetzen des abgeschiedenen Oxids des ersten Metalls einer Einwirkung von Sauerstoff in der Kammer.

5. Verfahren nach Anspruch 1, weiters umfassend - bevor das Target aktiviert wird, um Deposit-Atome des ersten Metalls innerhalb der Kammer zu sputtern, während der Metallfilm davor geschützt wird, den Sputteratomen ausgesetzt zu sein - die Bestimmung eines Sets von bekannten Strömungsgeschwindigkeiten und der damit in Zusammenhang stehenden Zeitdauer.

6. Verfahren nach Anspruch 5, worin die Bestimmung des Sets die Aktivierung des Targets und für jede bekannte Strömungsgeschwindigkeit in dem Set die Messung der Abnahme der Targetspannung im Verlauf der Zeit umfasst.

7. Verfahren nach Anspruch 1, worin als Ergebnis der reaktiven Abscheidung ein Film eines Oxids des ersten Metalls zu einer ersten Dicke auf dem Metallfilm abgeschieden wurde, wobei das Verfahren weiters die Wiederholung des Verfahrens nach Anspruch 1 zur Erhöhung der Dicke umfasst.

8. Verfahren nach Anspruch 2, worin das Inertgas Argon ist.

9. Verfahren nach Anspruch 1, worin der eingebrachte Sauerstoff als O₂ eingebracht wird.

10. Verfahren nach Anspruch 1, weiters umfassend die Bereitstellung einer Blende für das Substrat, worin das Schützen des Metallfilms das Anordnen der Blende über dem Substrat umfasst und worin das Aussetzen des Metallfilms einer Einwirkung das Entfernen der Blende über dem Substrat umfasst.

11. Verfahren nach Anspruch 1, worin das Metall des Metallfilms Fe oder eine Fe-Legierung ist.

12. Verfahren nach Anspruch 1, worin das erste Metall aus der aus Al, Ti, Ta, Y, Ga und In bestehenden Gruppe ausgewählt ist.

13. Verfahren nach Anspruch 1, worin das erste Metall eine Legierung aus zwei oder mehreren aus der aus Al, Ti, Ta, Y, Ga, In und Mg bestehenden Gruppe ausgewählten Metalls ist.

14. Verfahren nach Anspruch 1, weiters umfassend - nach dem reaktiven Abscheiden eines Films eines Oxids des ersten Metalls - die Wiederholung des Verfahrens nach Anspruch 1 zum reaktiven Sputtern eines Films eines Oxids von einem Metall, welches sich von dem ersten Metall und dem Metall des Metallfilms unterscheidet, um dadurch einen mehrschichtigen Metalloxidfilm auszubilden.

## Revendications

1. Procédé pour former un film d'oxyde métallique sur un film métallique contenant du fer dans une chambre de dépôt de pulvérisation cathodique comprenant:
réaliser dans la chambre une cible de pulvérisation cathodique d'un premier métal et d'un substrat sur lequel le film métallique contenant du fer est formé, le métal du fil métallique étant différent du premier métal;
activer la cible pour déposer par pulvérisation cathodique des atomes du premier métal à l'intérieur de la chambre tout en protégeant le film métallique d'une exposition aux atomes déposés par pulvérisation cathodique;
après l'activation de la cible, introduire l'oxygène dans la chambre à un débit d'écoulement connu;
après la stabilisation de l'écoulement de l'oxygène, exposer le film métallique à un dépôt réactif d'un oxyde du premier métal sur le film métallique; et
continuer le dépôt réactif durant une période de temps et terminer l'activation de la cible, lorsque la tension cible atteint une valeur prédéterminée, ladite période de temps et le débit d'écoulement connu étant sélectionnés pour assurer une oxydation minimale de la cible.

2. Procédé selon la revendication 1, comprenant en outre, avant l'activation de la cible pour déposer par pulvérisation atomique des atomes du premier métal à l'intérieur de la chambre tout en protégeant le film métallique d'une exposition aux atomes pulvérisés, l'activation de la cible en présence d'un gaz inerte tout en couvrant la cible pour retirer ainsi sensiblement l'oxygène de la surface de la cible.

3. Procédé selon la revendication 1, comprenant en outre, avant l'activation de la cible pour déposer par pulvérisation cathodique des atomes du premier métal à l'intérieur de la chambre tout en protégeant le film métallique d'une exposition aux atomes pulvérisés, l'attaque de la surface du film métallique.

4. Procédé selon la revendication 1, comprenant en outre, après le dépôt réactif durant ladite période de temps, l'exposition de l'oxyde déposé du premier métal à l'oxygène dans la chambre.

5. Procédé selon la revendication 1, comprenant en outre, avant l'activation de la cible pour déposer par pulvérisation cathodique des atomes du premier métal à l'intérieur de la chambre tout en protégeant le film métallique d'une exposition aux atomes pulvérisés, la détermination d'un ensemble de débit d'écoulement d'oxygène connu et de périodes de temps associées.

6. Procédé selon la revendication 5, dans lequel la détermination dudit ensemble comprend l'activation de la cible et, pour chaque débit d'écoulement connu dans l'ensemble, la mesure de la diminution de la tension de la cible en fonction du temps.

7. Procédé selon la revendication 1, dans lequel, par suite du dépôt réactif d'un film d'un oxyde du premier métal a été déposé en une première épaisseur sur le film métallique, et comprenant en outre la répétition du procédé selon la revendication 1 pour augmenter ainsi ladite épaisseur.

8. Procédé selon la revendication 2, dans lequel le gaz inerte est l'argon.

9. Procédé selon la revendication 1, dans lequel l'oxygène introduit est introduit comme gaz O₂.

10. Procédé selon la revendication 1, comprenant en outre la réalisation d'un obturateur pour le substrat, dans lequel la protection du film métallique comprend la localisation de l'obturateur sur le substrat, et dans lequel l'exposition du film métallique comprend le retrait de l'obturateur depuis au-dessus du substrat.

11. Procédé selon la revendication 1, dans lequel le métal du film métallique est Fe ou un alliage Fe.

12. Procédé selon la revendication 1, dans lequel le premier métal est sélectionné dans le groupe consistant en Al, Ti, Ta, Y, Ga et In.

13. Procédé selon la revendication 1, dans lequel le premier métal est un alliage de deux ou plusieurs métaux sélectionnés dans le groupe consistant en Al, Ti, Ta, Y, Ga, In et Mg.

14. Procédé selon la revendication 1, comprenant en outre, après le dépôt réactif d'un film d'un oxyde du premier métal, la répétition du procédé selon la revendication 1 pour déposer par pulvérisation cathodique de manière réactive un film d'un oxyde d'un métal différent du premier métal et du métal du film métallique pour former ainsi un film d'oxyde métallique multicouche.
